(19) **Europäisches Patentamt**

**European Patent Office**

**Office européen des brevets**

(11) **EP 1 148 631 B1**

(12) **FASCICULE DE BREVET EUROPEEN**

(45) Date de publication et mention
de la délivrance du brevet:
**20.09.2006 Bulletin 2006/38**

(51) Int Cl.:
***H03C 1/54*** *(2006.01)*

(21) Numéro de dépôt: **01201332.2**

(22) Date de dépôt: **11.04.2001**

(54) **Convertisseur de fréquence avec rejet de fréquence image**

Frequenzumsetzer mit Unterdrückung der Spiegelfrequenzen

Frequency translator with image frequency signal suppression

(84) Etats contractants désignés:
**DE FR GB**

(30) Priorité: **18.04.2000 FR 0004996**

(43) Date de publication de la demande:
**24.10.2001 Bulletin 2001/43**

(73) Titulaire: **Koninklijke Philips Electronics N.V.**
**5621 BA Eindhoven (NL)**

(72) Inventeurs:
• **Souto-Diey, Anabel**
**75008 Paris (FR)**

• **Langanay, Jérôme**
**75008 Paris (FR)**
• **Feron, Benoît**
**75008 Paris (FR)**

(74) Mandataire: **Chaffraix, Jean**
**Société Civile SPID,**
**156, Boulevard Haussmann**
**75008 Paris (FR)**

(56) Documents cités:
**EP-A- 0 903 846 WO-A-95/20284**
**US-A- 5 847 623**

**Description**

La présente invention concerne un convertisseur de fréquence, destiné à recevoir un signal d'entrée ayant une fréquence dite intermédiaire et un signal provenant d'un oscillateur ayant une fréquence dite d'oscillation, et à délivrer un signal de sortie ayant une fréquence dite radio, dont la valeur est égale à la valeur absolue de la différence entre la fréquence d'oscillation et la fréquence intermédiaire.

Un tel convertisseur de fréquence est connu de la spécification du circuit RF2640 produit par la société RF Micro-Devices. Ce circuit est destiné à générer un signal de sortie de nature asymétrique, sur la base d'un signal d'entrée de nature différentielle, le signal provenant de l'oscillateur étant lui aussi de nature asymétrique. Le signal de sortie est le résultat d'une multiplication entre le signal d'entrée et le signal provenant de l'oscillateur.

Si le signal de sortie d'un tel convertisseur de fréquence présente une composante dont la fréquence est égale à la différence entre la fréquence d'oscillation et la fréquence intermédiaire, Il présente également une composante parasite dont la fréquence est égale à la somme de la fréquence d'oscillation et de la fréquence Intermédiaire, qui est couramment appelée fréquence Image. Le signal de sortie du convertisseur de fréquence véhicule une information fréquentielle qui est alors partagée entre la fréquence radio et la fréquence image, alors qu'un récepteur de cette information sera configuré pour ne recevoir que la fréquence radio. La composante parasite doit donc être supprimée afin que seule la composante du signal de sortie du convertisseur de fréquence ayant la fréquence radio ne contienne l'information utile à transmettre, sans quoi le signal transmis sera inexploitable par le récepteur auquel ladite information est destinée. Ceci nécessite d'utiliser un dispositif de filtrage en appoint au convertisseur de fréquence.

WO 95/20284 décrit un modulateur quadra phase I/Q pour corriger des erreurs de phase typiquement présentes dans des signaux d'entrée LO en quadrature. Le circuit utilise une paire de cellules de Gilbert Des signaux I et Q sont appliqués aux bornes inférieures. Les bornes supérieures reçoivent une somme et une différence de signaux différentiels en quadrature et limités. Le résultat est de rendre le circuit moins sensible aux erreurs de phase LO et donc d'améliorer la réjection de l'image par rapport au circuit conventionnel qui utilise typiquement une cellule de Gilbert.

Le gain et la linéarité du convertisseur de fréquence connu sont insuffisants pour nombre d'applications et doivent être améliorés au moyen de composants externes au convertisseur, comme des lignes micro-rubans, ce qui complique encore l'utilisation du convertisseur connu.

La présente invention a pour but de remédier à ces inconvénients en proposant un convertisseur de fréquence capable de réaliser, de manière interne, une bonne réjection de la fréquence image, tout en offrant de bonnes performances en bruit et un gain et une linéarité améliorés par rapport au convertisseur connu.

En effet, la revendication 1 définit un convertisseur de fréquence selon l'invention.

La revendication 2 définit un mode de réalisation particulièrement avantageux de l'invention.

Ce mode de réalisation permet de réduire les longueurs des liaisons entre les différents éléments intégrés, et donc de réduire à un minimum le bruit généré par le convertisseur de fréquence.

Le convertisseur de fréquence conforme à l'invention peut être utilisé dans tout type d'application requérant une conversion de fréquence, particulièrement des translations de fréquence avant émission de signaux radioélectriques. Dans un de ces modes de mise en oeuvre, l'invention concerne donc également un appareil de radiotéléphonie, incluant une unité de traitement du signal et une antenne destinée à émettre un signal radiofréquence, caractérisé en ce qu'il inclut en outre un convertisseur de fréquence tel que définit dans la revendication 1.

L'invention sera mieux comprise à l'aide de la description suivante, faite à titre d'exemple non-limitatif et en regard des dessins annexés, dans lesquels:

- la figure 1 est un schéma fonctionnel partiel décrivant un appareil de radiotéléphonie mettant en oeuvre un convertisseur de fréquence selon l'invention,
- la figure 2 est un schéma électrique représentant un mode de réalisation préféré d'une partie d'un tel convertisseur de fréquence,
- la figure 3 est schéma fonctionnel représentant des moyens de combinaison mis en oeuvre dans un mode de réalisation particulier de l'invention, et
- la figure 4 est un diagramme fréquentiel illustrant les avantages de l'invention.

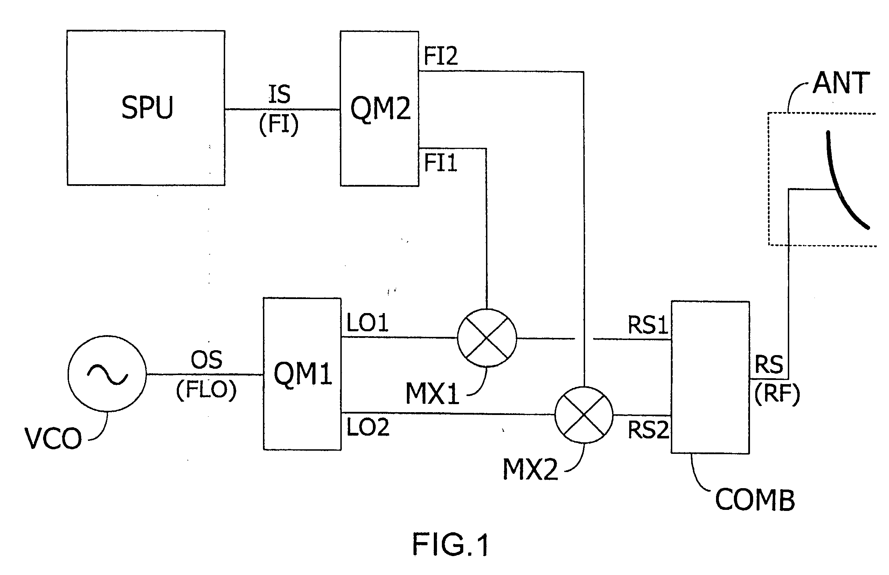

La figure 1 représente schématiquement un radiotéléphone, incluant une unité de traitement du signal SPU et une antenne ANT destinée à émettre un signal radiofréquence RS représentatif d'un signal dit d'entrée IS, issu de l'unité de traitement du signal SPU, ayant une fréquence FI appelée fréquence intermédiaire, dont la valeur moyenne est généralement choisie égale à 180MHz. La valeur instantanée de la fréquence du signal d'entrée IS constitue l'information véhiculée par ledit signal. Cette information doit se retrouver dans le signal radiofréquence RS. Un convertisseur de fréquence (QM1, QM2, MX1, MX2, COMB) est utilisé afin de d'attribuer au signal à transmettre RS une fréquence radio RF de valeur moyenne élevée, par exemple 835MHz selon la norme GSM. Pour ce faire, un oscillateur local VCO est utilisé, qui délivre un signal OS ayant une fréquence d'oscillation FLO élevée, qui sera égale à 1015MHz dans l'exemple choisi ci-dessus. Ce signal OS est multiplié par le signal d'entrée IS au moyen de mélangeurs MX1,MX2, de sorte que RF=FLO-FI. Le convertisseur de fréquence selon l'invention n'introduit pas dans le signal radiofréquence RS, qui constitue son signal de sortie, de composante à la fréquence image FLO+FI, qui serait égale à 1195MHz dans l'exemple du standard GSM. Le convertisseur de fréquence inclut dans ce but :

- un premier module quadratique QM1, destiné à recevoir le signal de sortie OS de l'oscillateur VCO et à délivrer un premier et un deuxième signal de sortie LO1 et LO2 en quadrature de phase l'un par rapport à l'autre et ayant tous deux pour fréquence la fréquence d'oscillation FLO,
- un deuxième module quadratique QM2, destiné à recevoir le signal d'entrée IS du convertisseur et à délivrer un premier et un deuxième signal de sortie FI1 et FI2 en quadrature de phase l'un par rapport à l'autre et ayant tous deux pour fréquence la fréquence intermédiaire FI,
- un premier mélangeur MX1, destiné à délivrer un signal de sortie RS1 représentatif d'un produit entre les premiers signaux de sortie LO1 et FI1 des premier et deuxième modules quadratiques QM1 et QM2,
- un deuxième mélangeur MX2, destiné à délivrer un signal de sortie RS2 représentatif d'un produit entre les deuxièmes signaux de sortie LO2 et FI2 des premier et deuxième modules quadratiques QM1 et QM2, et
- des moyens de combinaison COMB pour recombiner les signaux de sortie RS1 et RS2 des premier et deuxième mélangeurs MX1 et MX2.

Les avantages de l'invention peuvent être aisément compris à la lumière de l'exemple suivant, dans lequel le signal d'entrée IS du convertisseur de fréquence s'exprime sous la forme IS=$\sin(\omega_{FI}.t)$, tandis que le signal de sortie OS de l'oscillateur VCO s'exprime sous la forme OS=$\sin(\omega_{LO}.t)$, avec $\omega_{FI}=2\Pi.FI$ et $\omega_{LO}=2\Pi.FLO$ Dans cet exemple, les premier et deuxième modules quadratiques QM1 et QM2 sont agencés de manière à générer des premier et deuxième signaux (FI1 ; FI2) et (LO1 ; LO2) respectivement, s'exprimant sous la forme :

$$FI1 = \sin(\omega_{FI}.t+\Pi)$$
$$FI2 = \sin(\omega_{FI}.t+3\Pi/2)$$
$$LO1 = \sin(\omega_{LO}.t+\Pi/4)$$
$$LO2 = \sin(\omega_{LO}.t+3\Pi/4)$$

Les signaux de sortie RS1 et RS2 des premier et deuxième mélangeurs MX1 et MX2, résultant des multiplications opérées par lesdits mélangeurs, s'écrivent alors, en utilisant les formules trigonométriques usuelles :

$$RS1 = (\sin((\omega_{LO}-\omega_{FI}).t+\Pi/4))/2 - (\sin((\omega_{LO}+\omega_{FI}).t+\Pi/4))/2,$$

et

$$RS2 = (\sin((\omega_{LO}+\omega_{FI}).t+\Pi/4))/2 + (\sin((\omega_{LO}-\omega_{FI}).t+\Pi/4))/2.$$

Après recombinaison desdits signaux de sortie, le convertisseur de fréquence délivre un signal RS représentatif de la somme des signaux de sortie RS1 et RS2 des premier et deuxième mélangeurs MX1 et MX2, qui s'exprime donc sous la forme RS= $\sin((\omega_{LO}-\omega_{FI}).t+\Pi/4)$ = $\sin(\omega_{RF}.t+\Pi/4)$, qui ne comprend donc plus qu'une composante ayant la fréquence radio égale à $\omega_{RF}/2\Pi$. Le convertisseur de fréquence conforme à l'invention réalise donc automatiquement une bonne réjection de la fréquence image, puisque aucune composante en $\sin((\omega_{LO}+\omega_{FI}).t)$ n'apparaît dans le signal de sortie RS du convertisseur de fréquence.

La séparation du signal de sortie d'un oscillateur en deux composantes déphasées de 90° l'une par rapport à l'autre est pratique courante dans l'industrie électronique et de nombreux modes de réalisation du premier module quadratique QM1 sont déjà bien documentés dans l'état de la technique. La réalisation du deuxième module quadratique QM2, et son interaction avec les premier et deuxième mélangeurs MX1 et MX2 peuvent être optimisés de façon à fournir la meilleure linéarité possible et le gain le plus élevé possible, tout en réduisant à un minimum le bruit généré par les multiplications opérées par les mélangeurs MX1 et MX2.

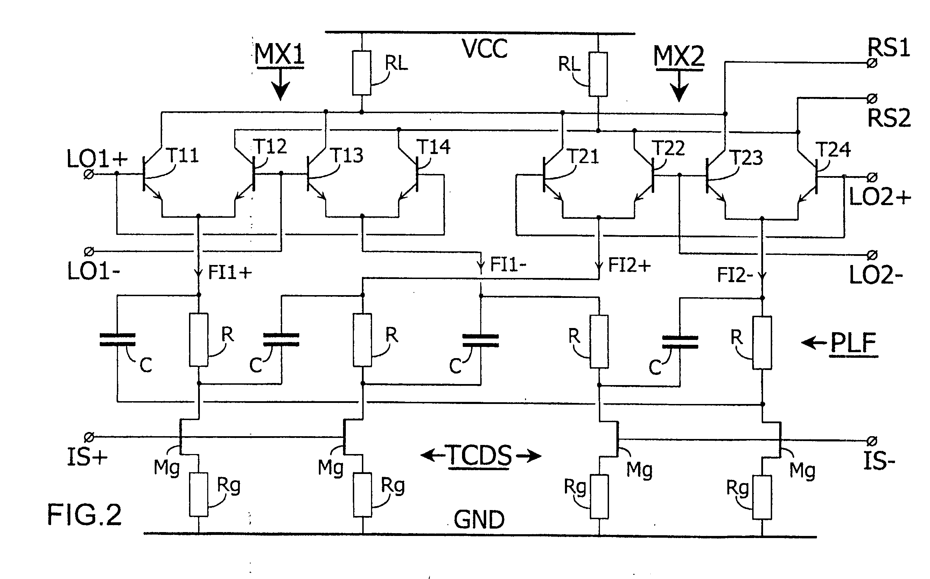

La figure 2 est un schéma électrique qui représente un tel mode de réalisation du deuxième module quadratique et des premier et deuxième mélangeurs MX1 et MX2, qui sont ici incorporés dans un même circuit intégré. Dans ce mode de réalisation, le signal d'entrée IS du convertisseur de fréquence est un signal de tension différentiel (IS+,IS-), et les premier et deuxième signaux de sortie LO1 et LO2 du premier module quadratique QM1 sont également de nature différentielle (LO1+,LO1-) et (LO2+,LO2-).

Le deuxième module quadratique inclut un étage transconductance TCDS permettant de transformer l'information de tension constituée par le signal d'entrée (IS+,IS-) en une information de courant. Cet étage transconductance est constitué par des résistances Rg, disposées en série avec des transistors Mg, dont la conduction est contrôlée par le signal d'entrée (IS+,IS-). L'association d'un transistor avec une résistance forme une source de courant destinée à générer un courant dont la valeur est proportionnelle à la valeur de la tension de contrôle des transistors, et donc, dans le cas présent, à la valeur du signal d'entrée (IS+,IS-). On choisira avantageusement des transistors de type NMOS pour obtenir la meilleure linéarité possible dans la conversion tension/courant.

Le deuxième module quadratique inclut en outre un filtre polyphase PLF, constitué par un réseau RC, permettant de produire un premier et un deuxième courant différentiel (FI1+,FI1-) et (FI2+,FI2-), déphasés l'un par rapport à l'autre de 90°. Ces courants différentiels forment les premier et deuxième signaux de sortie du deuxième module quadratique et sont représentatifs du signal d'entrée (IS+,IS-), dont la fréquence constitue l'information utile véhiculée par ledit signal. Le déphasage de 90° est obtenu en choisissant pour le pôle RC du filtre polyphase PLF une valeur telle que :

$$\Pi/2 = 2.arctan(2\Pi.R.C.FI), \text{ soit } RC = 1/\omega_{FI}.$$

Chaque mélangeur MXi (pour i=1 ou 2) inclut deux paires différentielles (Ti1,Ti2) et (Ti3,Ti4) formant une cellule de Gilbert, dont la conduction est destinée à être contrôlée par l'un des signaux de sortie (LOi+,LOi-) du premier module quadratique, et qui sont destinées à être polarisées au moyen de l'un des signaux de sortie (FIi+,FIi-) du deuxième module quadratique. Les collecteurs des transistors (Ti1,Ti3) sont tous reliés ensemble et forment une première borne de sortie destinée à délivrer le premier signal de sortie RS1. Les collecteurs des transistors (Ti2,Ti4) sont tous reliés ensemble et forment une deuxième borne de sortie destinée à délivrer le deuxième signal de sortie RS2. Chaque borne de sortie est en outre reliée à une borne d'alimentation VCC via une résistance de charge RL.

Le circuit intégré décrit dans cet exemple de réalisation est remarquable en ce qu'il réduit au minimum les interfaces entre le signal d'entrée IS du convertisseur de fréquence et les mélangeurs MX1 et MX2, réduisant ainsi le bruit généré par le circuit, et en ce que les éléments qu'il utilise, qui interagissent directement les uns avec les autres, présentent une grande linéarité.

Les liaisons nodales reliant les collecteurs des différentes paires différentielles peuvent être considérées comme formant partie des moyens de combinaison évoqués précédemment. De fait, elles ont pour effet d'additionner les contributions des signaux de sortie des deux mélangeurs MX1 et MX2 et génèrent des signaux RS1 et RS2 qui sont dépourvus de toute composante parasite à la fréquence image. Il est d'ailleurs possible de sélectionner l'un des premier ou deuxième signaux RS1 ou RS2 pour constituer le signal radiofréquence RF. Cependant, ceci provoquerait une perte de gain de 6dB. Il est préférable de combiner les deux signaux RS1 et RS2 ainsi générés en un seul signal, ce qui permettra de réduire dans une large mesure cette perte de gain.

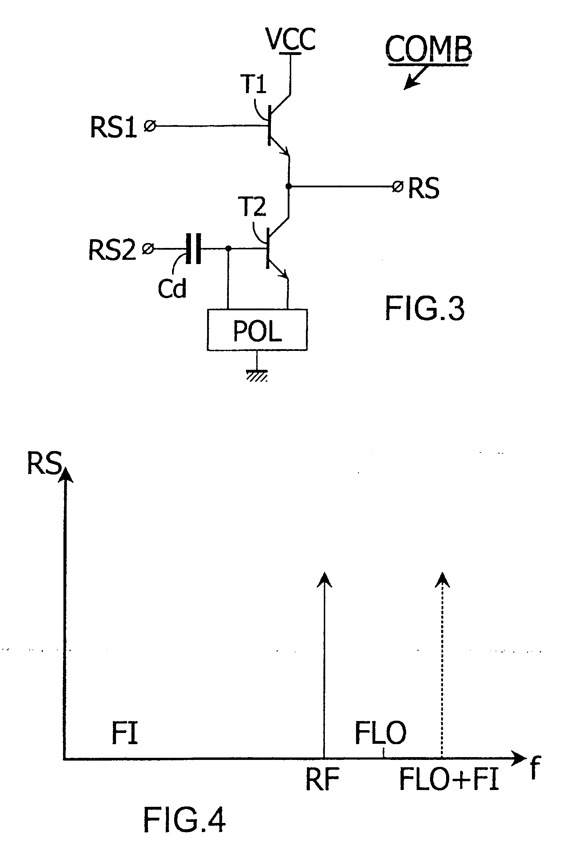

La figure 3 représente un mode de réalisation des moyens de combinaison COMB utilisés à cet effet. Ces moyens induent un premier et un deuxième transistor T1 et T2, disposés en série entre la borne d'alimentation VCC et une masse, transistors dont la conduction est respectivement contrôlée par les premier et deuxième signaux de sortie RS1 et RS2 des mélangeurs, le signal de sortie RS du convertisseur de fréquence étant alors prélevé à un noeud intermédiaire auxdits transistors T1 et T2. Le deuxième transistor T2 fait l'objet d'une polarisation spécifique pour éviter sa saturation. En effet, si, par exemple, la tension d'alimentation VCC est de 3 Volts, la valeur de la composante continue des signaux RS1 et RS2 serait idéalement 1,5 Volts afin de fournir auxdits signaux la plus large plage de variations instantanées possible. Ceci signifie que la valeur de la composante continue du signal de sortie RS est 1,5V-Vbe(T1), où Vbe(T1) est la tension base-émetteur du premier transistor T1, qui est typiquement voisine de 0,6 Volts. La plage de variation de la tension collecteur-émetteur du deuxième transistor T2, Vce(T2), n'est donc plus que de 0,9V, ce qui nécessite une polarisation particulière du deuxième transistor T2. A cet effet, une capacité de découplage Cd est disposée en amont de la base dudit transistor T2, et des moyens de polarisation POL, constitués par exemple par des résistances de base et d'émetteur selon des techniques bien connues de l'homme du métier, imposent à la base du deuxième transistor T2 un potentiel déterminé par ses conditions d'utilisation décrites précédemment.

La figure 4 illustre la réjection de la fréquence image réalisée par le convertisseur de fréquence selon l'invention. Le signal de sortie RS de ce convertisseur, qui est le résultat de la multiplication d'un signal ayant une fréquence intermédiaire FI par un signal ayant une fréquence d'oscillation FLO, présente une seule composante principale à une fréquence radio RF égale à FLO-FI. La composante à la fréquence image FLO+FI, représentée en traits pointillés sur la figure, et présente dans le signal de sortie du convertisseur connu, est supprimée à l'intérieur même du convertisseur de fréquence grâce à l'invention.

**Revendications**

1. Convertisseur de fréquence, destiné à recevoir un signal d'entrée (IS) ayant une fréquence intermédiaire (FI) et un signal (OS) provenant d'un oscillateur (VCO) ayant une fréquence d'oscillation (FLO), le convertisseur comportant :

   . un premier module quadratique (QM1), destiné à recevoir le signal de sortie (OS) de l'oscillateur (VCO) et à délivrer un premier et un deuxième signal de sortie (LO1, LO2) en quadrature de phase l'un par rapport à l'autre et ayant tous deux pour fréquence la fréquence d'oscillation (FLO),
   . un deuxième module quadratique (QM2), destiné à recevoir le signal d'entrée (IS) du convertisseur de fréquence et à délivrer un premier et un deuxième signal de sortie (FI1, FI2) en quadrature de phase l'un par rapport à l'autre et ayant tous deux pour fréquence la fréquence Intermédiaire (FI),
   . un premier mélangeur (MX1) incluant un étage différentiel (T11, T12), destiné à délivrer un signal de sortie (RS1) représentatif d'un produit entre les premiers signaux de sortie (LO1, FI1) des premier et deuxième modules quadratiques (QM1, QM2),
   . un deuxième mélangeur (MX2) incluant un étage différentiel (T21, T22), destiné à délivrer un signal de sortie (RS2) représentatif d'un produit entre les deuxièmes signaux de sortie (LO2, F12) des premier et deuxième modules quadratiques (QM1, QM2), et
   . des moyens de combinaison pour recombiner les signaux de sortie (RS1, RS2) des premier et deuxième mélangeurs (MX1, MX2),pour délivrer un signal de sortie (RS) ayant une fréquence radio (RF), dont la valeur est égale à la valeur absolue de la différence entre la fréquence d'oscillation (FLO) et la fréquence intermédiaire (FI),

   le convertisseur de fréquence comprenant un étage de transconductance (TDSC) pour générer à partir du signal d'entrée (IS) du convertisseur de fréquence, un signal d'entrée pour le deuxième module quadratique sous forme d'une pluralité de courant d'entrées,
   le deuxième module quadratique (QM2) comprenant un filtre polyphase (PLF) permettant de produire une pluralité de courants de sortie (FI1+, FI1-, FI2+, FI2-), déphasés les uns par rapport aux autres et représentatifs de l'information véhiculée par le signal d'entrée (IS), un desdits courant de sortie (FI1+) étant injecté dans l'étage différentiel (T11, T12) du premier mélangeur (MX1) et un autre desdits courant de sortie (T21, T22) étant injecté dans l'étage différentiel (T22, T21) du deuxième mélangeur (MX2).

2. Convertisseur de fréquence selon la revendication 1, dans lequel le deuxième module quadratique (QM2) et les premier et deuxième mélangeurs (MX1, MX2) sont Incorporés au sein d'un même circuit intégré.

3. Appareil de radiotéléphonie, incluant une unité de traitement du signal (SPU) et une antenne (ANT) destinée à émettre un signal radiofréquence, **caractérisé en ce qu'**il inclut en outre un convertisseur de fréquence conforme à la revendication 1, destiné à recevoir son signal d'entrée (IS) depuis l'unité de traitement du signal (SPU), convertisseur de fréquence dont le signal de sortie (RS) constitue le signal radiofréquence.

**Claims**

1. A frequency converter designed for receiving an input signal (IS) having an intermediate frequency (FI) and a signal (OS) originating from an oscillator (VCO) and having an oscillation frequency (FLO), which converter comprises:

   - a first quadratic module (QM1) designed for receiving the output signal (OS) from the oscillator (VCO) and for supplying a first and a second output signal (LO1, LO2) in mutual phase quadrature, both having the oscillation frequency (FLO) as their frequency,
   - a second quadratic module (QM2) designed for receiving the input signal (IS) of the frequency converter and for supplying a first and a second output signal (FI1, FI2) in mutual phase quadrature, both having the intermediate frequency (FI) as their frequency,
   - a first mixer (MX1) comprising a differential stage (T11, T12) and designed for supplying an output signal (RS1) which represents a product of the first output signals (LO1, FI1) of the first and second quadratic modules (QM1, QM2),
   - a second mixer (MX2) comprising a differential stage (T21, T22) and designed for supplying an output signal (RS2) representing a product of the second output signals (LO2, FI2) of the first and second quadratic modules (QM1, QM2), and
   - combination means for recombining the output signals (RS1, RS2) of the first and second mixers (MX1, MX2) so as to deliver an output signal (RS) having a radio frequency (RF) whose value is equal to the absolute value of the difference between the oscillation frequency (FLO) and the intermediate frequency (FI),

said frequency converter comprising a transconductance stage (TDSC) for generating from the frequency converter's input signal (IS) an input signal for the second quadratic module in the form of a plurality of input currents, said second quadratic module (QM2) comprising a multiphase filter (PLF) capable of producing a plurality of output currents (FI1+, FI1-, FI2+, FI2-) out of phase with one another and representative of the information carried by the input signal (IS), one of said output currents (FI1+) being injected into the differential stage (T11, T12) of the first mixer (MX1) and another one of said output currents (T21, T22) being injected into the differential stage (T21, T22) of the second mixer (MX2).

2. A frequency converter as claimed in claim 1, wherein the second quadratic module (QM2) and the first and the second mixer (MX1, MX2) are incorporated within one and the same integrated circuit.

3. A wireless telephony device comprising a signal processing unit (SPU) and an antenna (ANT) designed for transmitting a radio frequency signal, **characterized in that** it comprises in addition a frequency converter as claimed in claim 1 and designed for receiving its input signal (IS) from the signal processing unit (SPU), while the output signal (RS) of said frequency converter forms the radio frequency signal.

**Patentansprüche**

1. Frequenzumsetzer, bestimmt für den Empfang eines Eingangssignals (IS) mit einer Zwischenfrequenz (FI) und eines Signals (OS), kommend aus einem Oszillator (VCO) mit einer Oszillationsfrequenz (FLO), wobei der Umsetzer aufweist:

. ein erstes quadratisches Modul (QM1), bestimmt für den Empfang des Ausgangssignals (OS) des Oszillators (VCO) und die Abgabe eines ersten und eines zweiten gegenseitig um 90° phasenverschobenen Ausgangssignals (LO1, LO2), die alle beide die Oszillationsfrequenz (FLO) als Frequenz haben,
. ein zweites quadratisches Modul (QM2), bestimmt für den Empfang des Eingangssignals (IS) des Frequenzumsetzers und die Abgabe eines ersten und eines zweiten gegenseitig um 90° phasenverschobenen Ausgangssignals (FI1, FI2), die alle beide die Zwischenfrequenz (FI) als Frequenz haben,
. einen ersten Mischer (MX1) mit einer Differenzialstufe (TI1, TI2), für die Abgabe eines Ausgangssignals (RS1) bestimmt, repräsentativ für ein Produkt von den ersten Ausgangssignalen (LO1, FI1) mit dem ersten und dem zweiten quadratischen Modul (QM1, QM2),
. einen zweiten Mischer (MX2) mit einer Differenzialstufe (T21, 122), für die Abgabe eines Ausgangssignals (RS2) bestimmt, repräsentativ für ein Produkt von den zweiten Ausgangssignalen (LO2, FI2) mit dem ersten und dem zweiten quadratischen Modul (QM1, QM2), und
. Kombinationsmitteln für die Rekombination der Ausgangssignale (RS1, RS2) des ersten und des zweiten Mischers (MX1, MX2), um ein Ausgangssignal (RS) mit einer Radiofrequenz (RF) auszugeben, dessen Wert gleich dem absoluten Wert des Unterschieds zwischen der Oszillationsfrequenz (FLO) und der Zwischenfrequenz (FI) ist,

wobei der Frequenzumsetzer eine Transkonduktanzstufe (TDSC) enthält, um anhand des Eingangssignals (IS) des Frequenzumsetzers ein Eingangssignal für das zweite quadratische Modul in der Form einer Vielzahl von Eingangsströmen zu erzeugen, und das zweite quadratische Modul (QM2) einen Vielphasenfilter (PLF) enthält, der die Erzeugung einer Vielzahl von Ausgangsströmen (FI1+, FI1-, FI2+, F12-) ermöglicht, gegenseitig in der Phase verschoben und repräsentativ für die von dem Eingangssignal (IS) übertragene Information, wobei einer der besagten Ausgangsströme (FI1+) in die Differenzialstufe (T11, T12) des ersten Mischers (MX1) und ein anderer der besagten Ausgangsströme (T21, T22) in die Differenzialstufe (T22, T21) des zweiten Mischers (MX2) injiziert werden.

2. Frequenzumsetzer nach Anspruch 1, in dem das zweite quadratische Modul (QM2) und der erste und der zweite Mischer (MX1, MX2) in einen selben integrierten Schaltkreis eingebaut sind.

3. Radiofernsprechgerät mit einer Signalverarbeitungseinheit (SPU) und einer dafür bestimmten Antenne (ANT), ein Radiofrequenzsignal auszustrahlen, **dadurch gekennzeichnet, dass** es außerdem einen Anspruch 1 entsprechenden Frequenzumsetzer enthält, der für den Empfang seines Eingangssignals (IS) von der Signalverarbeitungseinheit (SPU) bestimmt ist, wobei das Ausgangssignal (RS) des Frequenzumsetzers das Radiofrequenzsignal bildet.

FIG.1

EP 1 148 631 B1

FIG.2

VCC

T1

RS1 ⊘

T2

RS2 ⊘ ——||—— 
Cd

POL

⊘ RS

COMB

FIG.3

RS

FI

FLO

RF

FLO+FI

f

FIG.4